# FASCICULE DE BREVET EUROPEEN

(11) **EP 2 978 871 B1**
(45) Date de publication et mention de la délivrance du brevet: **05.04.2017**
(21) Numéro de dépôt: 14706065.1
(22) Date de dépôt: 25.02.2014
(51) Int. Cl.: C23C 16/04, C23C 16/511, C23C 16/27, H05H 1/18, H01J 37/32

(54) **PROCÉDÉ DE DÉPÔT DE DIAMANT EN PHASE VAPEUR**
VERFAHREN FÜR EINE DIAMANTDAMPFABSCHEIDUNG
METHOD FOR A DIAMOND VAPOR DEPOSITION

(30) Priorité: 28.03.2013 EP 13161778
(43) Date de publication de la demande: 03.02.2016
(73) Titulaire: NeoCoat SA, 2300 La Chaux-de-Fonds (CH)
(72) Inventeur: RATS, David, CH-2000 Neuchâtel (CH); PROVENT, Christophe, F-01170 Cessy (FR)
(74) Mandataire: Gevers SA
(86) Numéro de dépôt international: PCT/EP2014/053658
(87) Numéro de publication internationale: WO 2014/154424

(56) Documents cités:
- EP-A1- 1 752 566
- WO-A1-03/103003

## Description

### Domaine technique

La présente invention se rapporte au domaine de dépôt de diamant sur un substrat, particulièrement au dépôt de diamant nanocristallin en phase vapeur. Par diamant nanocristallin, on entend du diamant polycristallin, présentant une taille de grain compris entre 1 et 50 nm, typiquement autour de 10 nm, permettant d'obtenir une rugosité moyenne inférieure à 100 nm, de préférence inférieure à 20 nm.

### Etat de la technique

Le diamant est un matériau comportant des propriétés exceptionnelles comme sa grande dureté, son module de Young élevé ou sa grande conductivité thermique. Il est possible de le synthétiser en couche mince grâce à la méthode de dépôt chimique en phase vapeur (CVD) en activant thermiquement ou par plasma un mélange gazeux contenant au moins un précurseur de carbone et de l'hydrogène. L'activation de la phase gazeuse permet de créer des espèces radicalaires comme l'hydrogène atomique ou le radical méthyl avec une concentration suffisante pour assurer la croissance rapide d'une couche de diamant de grande qualité cristalline.

Les techniques généralement utilisées permettent d'obtenir du diamant polycristallin avec une taille de grain de l'ordre du micron pour une épaisseur inférieur à dix microns. Cette taille de grain importante entraine une rugosité moyenne de surface supérieure à 100 nm rendant impossible son utilisation pour des applications tribologiques ou d'intégration dans les composants électroniques ou les microsystèmes (MEMS).

C'est par exemple le cas avec une activation thermique du mélange gazeux réactionnel par filament chaud (HFCVD pour Hot Filament Chemical Vapour Déposition). Cette technique permet des dépôts sur de grandes surfaces (>0.5m²) mais avec des grains dont la taille, de l'ordre du micron, n'est pas satisfaisante. De plus, la température de dépôt est très supérieure à 400°C, usuellement supérieure à 750°C. Par conséquent, lorsque le substrat se refroidit après le dépôt, il subit des déformations thermiques selon un coefficient différent du diamant. La déformation différentielle entraîne fréquemment des contraintes ou des défauts au niveau de la couche de diamant ou de l'interface avec la couche de diamant.

Pour obtenir des dépôts lisses, un post-traitement comme un polissage est possible, mais il est couteux et peu adapté à des pièces de géométrie complexe, c'est-à-dire des pièces présentant des parties en relief par rapport à un plan de référence, ou des pièces tridimensionnelles. Par pièce complexe, on définit une pièce sur laquelle un dépôt de diamant produit une couche dont la surface n'est pas plane (on peut ici négliger la rugosité du dépôt). En d'autres termes, la surface de la couche de diamant, c'est-à-dire la couche sans tenir compte de sa propre épaisseur, est tridimensionnelle.

Une autre solution est de déposer une couche de diamant nanocristallin en favorisant la nucléation continue pendant le dépôt. Le diamant obtenu peut avoir une taille de grain de l'ordre d'une dizaine de nanomètres et une rugosité moyenne inférieure à 20 nanomètres. A cet effet, la technologie plasma micro-onde conventionnelle permet de déposer du diamant nanocristallin de bonne qualité, mais sur de petites surfaces (<0.05 m²) et à des températures supérieures à 400°C (usuellement >600°C), entraînant des contraintes thermiques similaires à celles évoquées ci-dessus.

Les deux techniques susmentionnées utilisent des pressions de travail supérieures à 10 mbar engendrant des phénomènes de convexion peu favorables à la diffusion des espèces radicalaires dans des espaces de faibles dimensions.

Pour pouvoir traiter des pièces à l'échelle industrielle, une surface de dépôt supérieure à 0.1 m² est exigée pour obtenir un cout de traitement limité.

Le document WO03/103003 divulgue un dispositif de production d'une nappe plasma, qui pourrait entre autre être utilisé pour le dépôt de diamant, mettant en oeuvre un équipement de dépôt en phase vapeur comprenant un réacteur sous vide et une pluralité de sources de plasma disposées selon une matrice. Ce dispositif vise, certes, à effectuer des traitements sur des surfaces importantes, mais sans considération pour des conditions de dépôt particulières, notamment pour la température, ni pour obtenir une qualité de couche spécifique (taille de grains et rugosité).

De plus, pour avoir un dépôt uniforme sur des pièces structurées dans la masse ou entièrement ouvertes, il est important que les espèces radicalaires puissent être transportées dans des espaces réduits avec une probabilité faible de recombinaison (besoin de durée de vie suffisamment longue).

Enfin, pour pouvoir déposer une couche de diamant nanocristallin sans altérer les propriétés intrinsèques du matériau à revêtir ou ses tolérances géométriques, il est important de le déposer à basse température pour minimiser les déformations thermiques et les contraintes résultant d'un comportement thermique différent entre le diamant et le substrat.

On connait l'utilisation d'une technologie plasma avec un couplage de l'énergie micro-onde à travers des ondes de surface, qui permet de réduire la température de dépôt à une valeur proche de 100°C. Toutefois, les dispositifs connus ne permettent pas d'appliquer aisément une couche régulière de diamant sur un substrat de forme complexe.

La présente invention a pour but de résoudre ces problèmes.

### Divulguation de l'invention

De façon plus précise, l'invention concerne un procédé de dépôt de diamant, et une pièce obtenue selon ce procédé, tels que mentionnés dans les revendications.

### Brève description des dessins

D'autres détails de l'invention apparaîtront plus clairement à la lecture de la description qui suit, faite en référence au dessin annexé dans lequel :
- la figure 1 est une vue représentant un équipement de dépôt de diamant utilisé avantageusement dans le procédé selon l'invention,
- les figures 2, 3, 4 et 5 donnent des illustrations de substrats pouvant être avantageusement recouverts de diamant par un procédé selon l'invention, et
- les figures 6 et 7 représentent respectivement un dépôt non conforme tel qu'on l'obtient avec les techniques de l'état de la technique et un dépôt conforme obtenu par la présente invention.

### Mode de réalisation de l'invention

Ainsi qu'on l'a mentionné ci-dessus, on peut réaliser des dépôts de diamant nanocristallin en mettant en oeuvre la technologie de dépôt chimique en phase vapeur par plasma, sur divers substrats, qui seront définis ci-après. Cependant, les équipements de l'état de la technique ne permettent pas de réaliser des dépôts sur des substrats de forme complexe. On définit un substrat de forme complexe comme un substrat présentant des parties en relief, c'est-à-dire en creux ou en saillie, par rapport à un plan de référence, ou des pièces tridimensionnelles. Ainsi, un dépôt de diamant sur une telle pièce produit une couche non plane, c'est-à-dire que des vecteurs normaux à la surface du dépôt ne sont pas tous parallèles entre eux. En d'autres termes, la surface de la couche de diamant, c'est-à-dire la couche sans tenir compte de sa propre épaisseur, est tridimensionnelle.

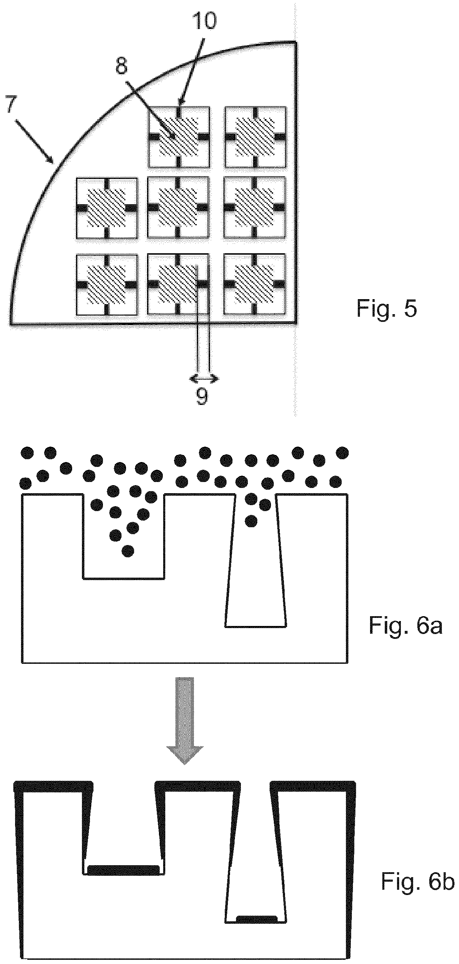

Par exemple, les figures 6a et 6b illustrent un dépôt obtenu par des techniques de l'art antérieur. Sur la figure 6a, on voit le mélange gazeux réactionnel symbolisé par les points, qui tente de pénétrer dans les structures du substrat, mais sans parvenir à se répartir de manière homogène, particulièrement dans le fond des structures, et surtout si celles-ci sont profondes et étroites. Sur la figure 6b, les traits épais représentent le dépôt de diamant. On peut voir qu'il n'est pas uniforme sur toute la surface du substrat, particulièrement dans le fond des structures.

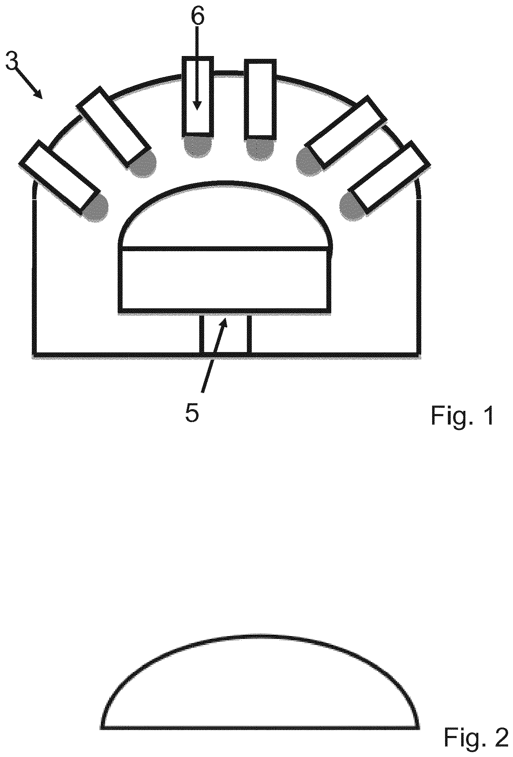

Selon l'invention, on réalise ces dépôts sur ce genre de substrat en mettant en oeuvre la technologie de dépôt par plasma micro-onde utilisant une matrice de sources plasma ponctuelles (MEPS, en anglais Matrix Elementary Plasma Source) avec un équipement tel que proposé sur la figure 1.

Ce système de dépôt comporte un réacteur sous vide 3, un porte-substrat 5 et une source de plasma par onde de surface, ici des applicateurs coaxiaux 6 arrangés selon une matrice tridimensionnelle, dans la paroi du réacteur sous vide 3. On peut noter que, si on veut réaliser un dépôt sur une surface plane, les applicateurs pourraient aussi être disposés selon une matrice bidimensionnelle. De préférence, les applicateurs coaxiaux présentent chacun, à leur extrémité située dans la chambre de réaction, une fenêtre de quartz ou d'alumine, définissant une zone active située dans la chambre de réaction. Ce type d'applicateur est disponible commercialement et n'a pas besoin d'être décrit en détail.

De préférence, la matrice permet d'avoir un dépôt homogène et qualitatif avec un nombre de source par mètre carré de plasma compris entre 80 et 320. A titre d'exemple, on peut avoir de l'ordre de 8 à 32 sources pour une surface de plasma de 0,1m², qui correspond sensiblement à un porte-substrat de 300x300mm². La surface de plasma est définie comme étant la surface formée par le plasma fourni par les différentes sources. Cette surface peut varier en fonction de la forme du plasma et de sa courbure, qui est elle-même adaptée en fonction de la surface à revêtir.

Grâce à l'utilisation d'une matrice de sources plasma ponctuelles, il est possible d'abaisser la pression de travail à une valeur inférieure à 1 mbar, de préférence comprise entre 0.1 et 1mbar. Une telle pression permet de favoriser les phénomènes de diffusion des espèces chimiques et donc d'avoir des dépôts très homogènes dans les reliefs du substrat et, le cas échéant, sur les flancs de structures qu'il présente, sans altération des propriétés du diamant.

On peut également travailler avec une température comprise entre 100°C et 500°C, ce qui permet de limiter les déformations thermiques du substrat, particulièrement avec un substrat métallique. Ainsi, lors du refroidissement du substrat revêtu, le différentiel de déformation entre le substrat et la couche de diamant est réduit, ce qui limite d'autant les contraintes mécaniques à l'interface des matériaux, sans devoir recourir à des couches intermédiaires.

Un autre avantage de cette technique de dépôt par matrice de sources plasma ponctuelles est qu'il n'existe pas de limitation physique au nombre d'applicateurs coaxiaux ou d'ouvertures dans le guide d'onde ou dans le réacteur permettant ainsi d'obtenir une surface de dépôt effective très grande.

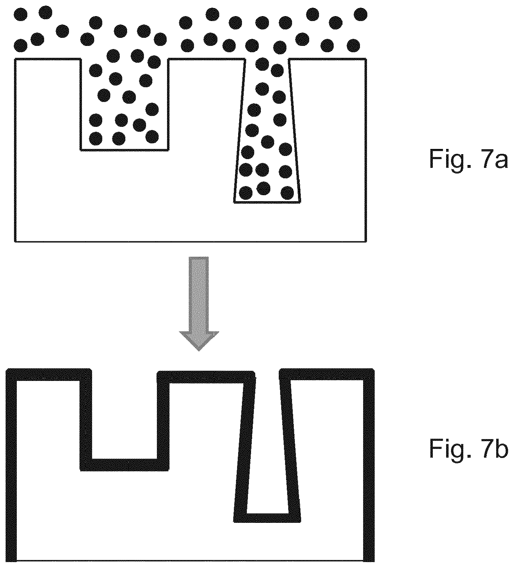

On peut voir sur la figure 7a, que grâce aux conditions réactionnelles, le mélange gazeux réactionnel, symbolisé par les points, parvient à pénétrer dans les structures du substrat et se répartit de manière homogène, particulièrement dans le fond des structures, même si celles-ci sont profondes et étroites. Sur la figure 7b, les traits épais représentent le dépôt de diamant. On peut voir que le dépôt est uniforme sur toute la surface du substrat, y compris dans le fond des structures, contrairement à ce qu'on observait sur la figure 6b.

En mettant en oeuvre cette installation, on peut ainsi effectuer un dépôt de diamant nanocristallin sur une pièce complexe telle que proposée à la figure 2, présentant une surface convexe. Naturellement, un dépôt sur une surface concave est aussi possible. Une telle pièce peut être réalisée en un matériau choisi parmi les matériaux suivants : silicium et composés à base de silicium, diamant, métaux réfractaires et dérivés, métaux de transition et dérivés, aciers inoxydables, alliages à base de titane, superalliages, carbures cémentés, polymères, céramiques, verres, oxydes (silice fondue, alumine), semi-conducteurs des colonnes III-V ou II-VI de la classification périodique. La pièce à déposer peut également comporter une base réalisée en un matériau quelconque, revêtue d'une couche mince des matériaux précédemment cités qui définit le substrat pour le dépôt de diamant. Une telle pièce peut aussi être constituée d'un assemblage de plusieurs matériaux formant une surface hétérogène (microprocesseur, MEMS, MOEMS, capteurs, etc.).

Selon un exemple particulier, le substrat tel que représenté sur la figure 2 est en inox de nuance 316L, de forme hémisphérique, uniquement ensemencé par une méthode de l'état de l'art et sans aucun prétraitement additionnel ou dépôt préalable d'une couche intermédiaire, telle qu'une barrière de diffusion.

Une couche de 200 nm de diamant nanocristallin a été déposée en utilisant la méthode de dépôt chimique en phase vapeur assistée par matrice de sources plasma ponctuelles au moyen d'une installation telle que décrite ci-dessus avec les conditions de dépôt suivantes:
- Température du substrat = 300°C,
- Pression de travail = 0.5mbar.

La couleur du dépôt est rose vert clair. Un contrôle de l'épaisseur de la couche déposée (mesure par réflectométrie UV-VIS) et de la qualité du dépôt (mesure par spectrométrie Raman) montre que la variation d'uniformité (calculée par la formule = (min-max)/moyenne) est inférieur à 10% sur toute la surface déposée.

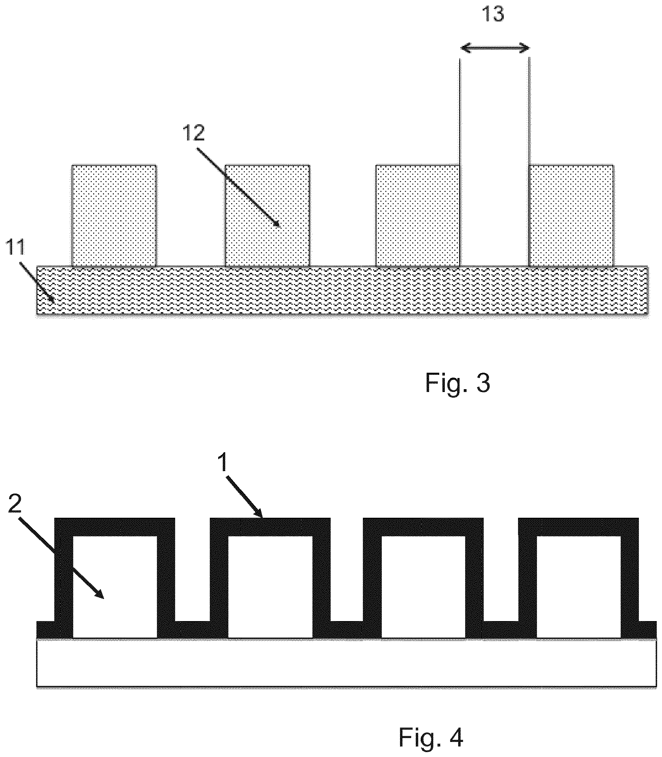

On peut également effectuer un dépôt de diamant nanocristallin sur une pièce structurée, telle que proposée à la figure 3. Grâce à une installation du type de celle décrite ci-dessus, on peut réaliser un revêtement sur l'ensemble de ses faces actives avec une grande homogénéité en épaisseur et qualité, comme schématisé sur la figure 4.

Selon un deuxième exemple, on a effectué un dépôt sur une pièce structurée, tel que proposée à la figure 3. Une telle pièce peut être réalisée en un matériau choisi parmi les matériaux suivants : silicium et composés à base de silicium, diamant, métaux réfractaires et dérivés, métaux de transition et dérivés, aciers inoxydables, alliages à base de titane, superalliages, carbures cémentés, polymères, céramiques, verres, oxydes (silice fondue, alumine), semi-conducteurs des colonnes III-V ou II-VI de la classification périodique. Comme ci-dessus, La pièce à déposer peut également comporter une base réalisée en un matériau quelconque, revêtue d'une couche mince des matériaux précédemment cités qui définit le substrat pour le dépôt de diamant. Une telle pièce peut aussi être constituée d'un assemblage de plusieurs matériaux formant une surface hétérogène (microprocesseur, MEMS, MOEMS, capteurs, etc.).

Plus particulièrement, sur un wafer de silicium monocristallin de 200mm de diamètre et 1 mm d'épaisseur 11, des structures carrées 12 de 1 mm de coté et de 0.1mm d'épaisseur ont été fabriquées par une méthode de photolithographie et gravure plasma, en ménageant un espace 13 entre deux structures consécutives d'environ 0.1mm.

Une couche de 200nm de diamant nanocristallin a été déposée en utilisant la méthode de dépôt chimique en phase vapeur utilisant une matrice de sources plasma ponctuelles au moyen d'une installation telle que décrite ci-dessus et avec les conditions de dépôt suivantes:
- Température du substrat = 300°C,
- Pression de travail = 0.5mbar.

Un contrôle de l'épaisseur de la couche déposée (mesure d'une coupe au microscope électronique à balayage) et de la qualité du dépôt (mesure par spectrométrie Raman) montre que la variation d'uniformité (calculée par la formule = (min-max)/moyenne) est inférieur à 10% sur toute l'épaisseur de la structure.

Sur la figure 5, on illustre un exemple supplémentaire, dans lequel un substrat structuré comportant des ouvertures sur toute son épaisseur ou dans la masse du substrat, est recouvert d'une couche de diamant nanocristallin. Plus précisément, sur un wafer de silicium monocristallin de 100mm de diamètre et 0.5mm d'épaisseur 7, des structures carrées 8 de 10mm de coté ont été découpées, typiquement par une méthode laser, en ménageant un espace 9 entre la structure et le support, dont la dimension est typiquement comprise entre 0,05 et 0,5mm. Chaque structure est maintenue par quatre poutres sensiblement de 0.1 mm de large.

Une couche de 200nm de diamant nanocristallin a été déposée en utilisant la méthode de dépôt chimique en phase vapeur utilisant une matrice de sources plasma ponctuelles au moyen d'une installation telle que proposée ci-dessus, avec les conditions de dépôt suivantes:
- Température du substrat = 300°C,
- Pression de travail = 0.5mbar.

Un contrôle de l'épaisseur de la couche déposée (mesure d'une coupe au microscope électronique à balayage) et de la qualité du dépôt (mesure par spectrométrie Raman) montre que la variation d'uniformité (calculée par la formule = (min-max)/moyenne) est inférieur à 10% sur toute l'épaisseur de la structure.

On a encore effectué un dépôt sur un substrat en forme d'un disque d'alliage base titane, Ti-4AI-6V (diamètre = 100mm et épaisseur 2mm) uniquement ensemencé par une méthode de l'état de l'art et sans aucun prétraitement additionnel ou dépôt préalable d'une couche intermédiaire, telle qu'une barrière de diffusion.

Une couche de 300nm de diamant nanocristallin a été déposée en utilisant la méthode de dépôt chimique en phase vapeur utilisant une matrice de sources plasma ponctuelles, en mettant en oeuvre une installation telle que décrite ci-dessus, avec les conditions de dépôt suivantes:
- Température du substrat = 300°C,
- Pression de travail = 0.5mbar.

La couleur du dépôt est rose pâle. Un contrôle de l'épaisseur de la couche déposée (mesure par réflectométrie UV-VIS) et de la qualité du dépôt (mesure par spectrométrie Raman) montre que la variation d'uniformité (calculée par la formule = (min-max)/moyenne) est inférieur à 10% sur toute la surface déposée.

Ainsi, comme une conséquence directe de la mise en oeuvre du procédé de dépôt chimique en phase vapeur selon l'invention utilisant une matrice de sources plasma ponctuelles au moyen d'une installation telle que proposée ci-dessus, on peut réaliser une couche de diamant nanocristallin dont l'épaisseur est comprise entre 50nm et plusieurs µm, typiquement jusqu'à 10µm, selon la durée du dépôt. Par rapport à des pièces revêtues de diamant, obtenues par des méthodes conventionnelles, on peut reconnaître une pièce obtenue par le procédé selon l'invention, par le fait que la variation d'uniformité (calculée par la formule = (min-max)/moyenne) est inférieure à 10% sur toute la surface déposée, et également par le fait que la taille de grain est comprise entre 1 et 50nm, typiquement autour de 10nm, permettant d'obtenir une rugosité moyenne inférieure à 100nm, de préférence inférieure à 20nm. De tels dépôts peuvent être effectués sur des surfaces supérieures à 0,1m².

## Revendications

1. Procédé de dépôt de diamant nanocristallin mettant en oeuvre un équipement de dépôt de diamant en phase vapeur comprenant :
- un réacteur sous vide (3) comprenant une chambre de réaction reliée à une source de vide,
- une pluralité de source ponctuelles de plasma micro-ondes disposées selon une matrice au moins bidimensionnelle dans la chambre de réaction,
- un porte-substrat (5) disposé dans le réacteur, ledit procédé étant **caractérisé en ce que** le dépôt est effectué à une température comprise entre 100 et 500°C et **en ce qu'**il est effectué à une pression comprise entre 0.1 et 1 mbar.

2. Procédé de dépôt selon la revendication 1, **caractérisé en ce qu'**il est réalisé sur un substrat présentant une surface tridimensionnelle.

3. Procédé de dépôt selon la revendication 2, **caractérisé en ce que** le substrat présente des éléments en relief, en creux ou en saillie, sur une surface définissant un plan de référence.

4. Procédé de dépôt selon la revendication 2, **caractérisé en ce que** le substrat présente une surface concave ou convexe.

5. Procédé selon la revendication 3 ou selon la revendication 4, **caractérisé en ce que** le substrat est choisi parmi les matériaux suivants : silicium et composés à base de silicium, diamant, métaux réfractaires et dérivés, métaux de transition et dérivés, aciers inoxydables, alliages à base de titane, superalliages, carbures cémentés, polymères, céramiques, verres, oxydes de type silice fondue ou alumine, semi-conducteurs des colonnes III-V ou II-VI de la classification périodique.

6. Procédé selon la revendication 5, **caractérisé en ce que** le substrat revêt une base réalisée en un matériau différent du substrat.

7. Procédé selon la revendication 5, **caractérisé en ce que** le substrat présente une surface hétérogène, formée par plusieurs matériaux.

## Patentansprüche

1. Verfahren für eine Abscheidung nanokristallinen Diamants, bei dem eine Ausrüstung für eine Diamantdampfabscheidung eingesetzt wird, umfassend:
- einen Vakuumreaktor (3), umfassend eine mit einer Vakuumquelle verbundene Reaktionskammer,
- eine Vielzahl punktueller Mikrowellen-Plasmaquellen, die gemäß einer mindestens zweidimensionalen Matrix in der Reaktionskammer angeordnet sind,
- einen Substratträger (5), der im Reaktor angeordnet ist,
wobei das Verfahren **dadurch gekennzeichnet ist, dass** die Abscheidung bei einer Temperatur im Bereich von 100 bis 500 °C durchgeführt wird und dass sie bei einem Druck im Bereich von 0,1 bis 1 mbar durchgeführt wird.

2. Abscheidungsverfahren nach Anspruch 1, **dadurch gekennzeichnet, dass** es auf einem Substrat durchgeführt wird, das eine dreidimensionale Oberfläche aufweist.

3. Abscheidungsverfahren nach Anspruch 2, **dadurch gekennzeichnet, dass** das Substrat Relief-, hohle oder hervorstehende Elemente auf einer Oberfläche aufweist, die eine Referenzebene definiert.

4. Abscheidungsverfahren nach Anspruch 2, **dadurch gekennzeichnet, dass** das Substrat eine konkave oder konvexe Oberfläche aufweist.

5. Verfahren nach Anspruch 3 oder nach Anspruch 4, **dadurch gekennzeichnet, dass** das Substrat aus den folgenden Materialien ausgewählt ist: Silizium und Verbindungen auf Siliziumbasis, Diamant, hitzebeständige Metalle und Derivate, Übergangsmetalle und Derivate, nichtrostende Stähle, Legierungen auf der Basis von Titan, Superlegierungen, Sinterkarbide, Polymere, Keramiken, Glas, Oxide vom Typ geschmolzenes Siliziumoxid oder Aluminiumoxid, Halbleiter der Spalten III-V oder II-VI des Periodensystems.

6. Verfahren nach Anspruch 5, **dadurch gekennzeichnet, dass** das Substrat eine Basis bedeckt, die aus einem anderen Material als das Substrat hergestellt ist.

7. Verfahren nach Anspruch 5, **dadurch gekennzeichnet, dass** das Substrat eine heterogene Oberfläche, gebildet von mehreren Materialien, aufweist.

## Claims

1. A nanocrystalline diamond deposition method implementing a piece of chemical vapor diamond deposition equipment comprising:
- a vacuum reactor comprising a reaction chamber connected to a vacuum source,
- a plurality of plasma sources, positioned according to an at least two-dimensional matrix in the reaction chamber,
- a substrate-holder positioned in the reactor,
said deposition being carried out at a temperature comprised between 100 and 500°C and at a pressure comprised between 0.1 and 1 mbar.

2. The deposition method according to claim 1, which is achieved on a substrate having a three-dimensional surface.

3. The deposition method according to claim 2, wherein the substrate has raised/recessed elements, either recessed or protruding, on a surface defining a reference plane.

4. The deposition method according to claim 2, wherein the substrate has a concave or convex surface.

5. The method according to claim 3 or claim 4 , wherein the substrate is selected from the following materials: silicon and silicon-based compounds, diamond, refractory metals and derivatives, transition metals and derivatives, stainless steels, titanium-based alloys, superalloys, cemented carbides, polymers, ceramics, glasses, oxides of the molten silica, alumina type, semiconductors of columns III-V or II-VI of the Periodic Classification.

6. The method according to claim 5, wherein the substrate is coated with a base made from a material different from the substrate.

7. The method according to claim 5, wherein the substrate has a heterogeneous surface, formed with several materials.
